Europäisches Patentamt

European Patent Office

Office européen des brevets

(11) Publication number: **0 091 548**
**B1**

(12) **EUROPEAN PATENT SPECIFICATION**

(45) Date of publication of patent specification: **15.11.89**

(51) Int. Cl.⁴: **H 01 L 29/06,** H 01 L 29/80, H 01 L 21/28, H 01 L 21/308

(21) Application number: **83101753.8**

(22) Date of filing: **23.02.83**

(54) Semiconductor structure comprising a mesa region, process for forming a semiconductor mesa; vertical field effect transistor and method of forming a vertical semiconductor device.

(30) Priority: **05.04.82 US 365806**

(43) Date of publication of application:
**19.10.83 Bulletin 83/42**

(45) Publication of the grant of the patent:
**15.11.89 Bulletin 89/46**

(84) Designated Contracting States:
**DE FR GB**

(56) References cited:
**EP-A-0 051 504**
**GB-A-2 064 868**
**GB-A-2 083 947**
**US-A-3 999 281**
**US-A-4 262 296**

**IEEE TRANSACTIONS ON ELECTRON DEVICES, vol. ED-28, no. 9, September 1981, New York, US; J.J.M. DEKKERS et al.: "Buried channel GaAs MESFET's-scattering parameter and linearity dependence on the channel doping profile"**

(73) Proprietor: **International Business Machines Corporation**
**Old Orchard Road**
**Armonk, N.Y. 10504 (US)**

(72) Inventor: **Jackson, Thomas Nelson**
**2 Feeney Road**
**Ossining New York 10562 (US)**

(74) Representative: **Hobbs, Francis John**
**IBM United Kingdom Limited Intellectual Property Department Hursley Park Winchester Hampshire SO21 2JN (GB)**

EP 0 091 548 B1

Courier Press, Leamington Spa, England.

## Description

This invention relates to a semiconductor structure comprising a mesa region, process for forming a semiconductor mesa; vertical field effect transistor and method of forming a vertical semiconductor device.

In general in this field, the smaller the device dimensions of a semiconductor device the greater the speed with which the device can operate. As extremely highspeed semiconductor devices are sought, the particularly small dimensions required are generally beyond the resolution of the standard photolithographic techniques currently used in the art.

One particular device structure is the field effect transistor wherein the source, the drain and the gate contacts are in line on the surface of the substrate and the distance between the source and drain electrodes thereof is being reduced to the range of around a half micron which is beyond the readily reproducible range of processing.

There have been approaches in the art to achieve the needed small dimensions indirectly. One approach that has been applied to the field effect type of transistor is through the use of the edge of a metal layer as the gate electrode. A typical such device is shown in the 1980 IEDM Technical Digest, Volume 24, No. 1, page 608, known as the permeable base transistor. This structure, however, as may be seen from the description requires great care to fabricate and the resulting structure has a high gate capacitance which introduces circuit limitations.

EP—A—0051504 which is comprised in the state of the art pursuant to EPC Article 54(3), discloses a field effect transistor comprising a gallium arsenide mesa epitaxial to and extending from a substantially planar portion of the surface of a gallium arsenide structure. The base of the mesa is blended into the planar portion of the surface of the structure. Metal gate contacts deposited on the surface of the structure make contact with the sides of the base of the mesa.

The invention seeks to provide a semiconductor structure which is an improvement over the prior art.

According to one aspect of the invention, a structure comprising a semiconductor portion surrounded by a semi-insulating portion, the semiconductor portion extending in the form of a mesa above a substantially planar surface of the semi-insulating portion is characterised by the mesa having a step therein so that it consists of a lower part and an upper part, each of constant cross-section, the lower part having a greater cross-section than the upper part.

According to another aspect of the invention, a process for forming a semiconductor mesa with a lower part having a greater cross-section than the upper part of the mesa, comprises forming an original mesa of constant cross-section, providing a conformal coating on the sides of the original mesa, downwardly eroding the material surrounding the original mesa using the conformal coating as a mask to form a final mesa consisting of an upper part which was the original mesa and a lower part of greater cross-section than the upper part.

How the invention can be carried out will now be described by way of example, with reference to the accompanying drawings in which:—

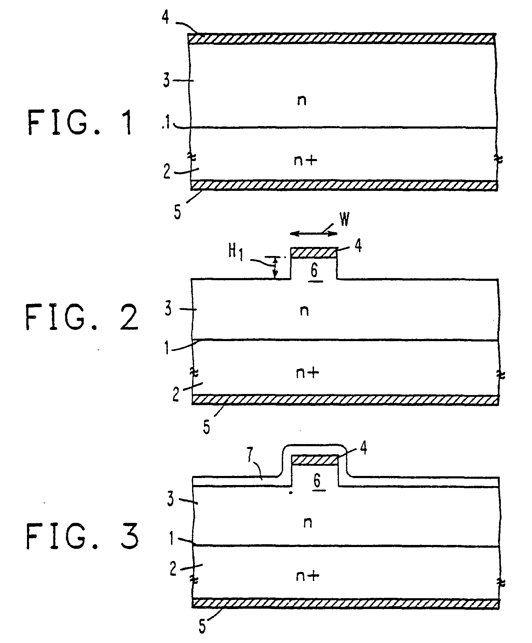

Figs. 1 to 9 illustrate successive stages in the fabrication of a vertical field effect transistor in accordance with the invention.

In practicing the invention, a thin coating is deposited on the side of a mesa. A vertical erosion step using the coating as a mask produces a horizontal shoulder on the mesa which in turn is usable for vertical positioning.

It will be assumed that the surface of a substrate is horizontal. A mesa is first formed on the substrate. The meas is to serve as at least a portion of a device to be fabricated. The horizontal dimensions are established using the edge of a precisely deposited resist and a perpendicular erosion or etching operation. Since the erosion is perpendicular to the surface, horizontal accuracy results. Accuracy in the direction perpendicular to the substrate is controlled by the etching or erosion which are very precise operations. A conformal coating is next placed over the surface of the substrate and over both the top and sides of the mesa. The coating is such that the portion on the horizontal surfaces is removable without significant removal of the portion of the sides of the mesa. The edge of the coating on the sides of the mesa is next used to control the horizontal extent of a perpendicular processing step that changes the characteristics of the substrate around the mesa so that the mesa now has a shoulder at the surface. An erosion step is next performed that removes the substrate surrounding the shoulder so that the mesa is elongated with the shoulder as a reference location at an intermediate position in the length. The coating on the sides of the mesa may now be removed and the shoulder and the relation thereof to the surface of the substrate and the ends of the mesa may be used for locating purposes in further processing.

The invention is illustrated in connection with the production of a vertical field effect transistor wherein the source to drain electrodes are separated by a mesa channel region having a shoulder to which is abutted a gate electrode. The field effect transistor structure is made by forming a mesa on a substrate with a height of the order of the channel length, placing thereover a conformal coating, removing the conformal coating except for the sides of the mesa, converting the area around the mesa to device isolating type material thereby establishing a shoulder on the mesa at the substrate surface, removing the insulating material around the mesa to a depth to expose a portion of the sides applying a gate metal coating over the semi-insulating material and the exposed sides of the mesa, and removing the metal coating between the gate and drain contacts by a "lift-off" technique by dissolving the remains of the conformal coating. The technique of the invention results in an epitaxial mesa with a shoulder between the extremities thereof.

The technique of the invention is illustrated in the accompanying drawings as applied to a field effect transistor and provides a vertical channel region through the use of the edge of a conformal coating applied to the sides of a mesa and the use of further eroding processing to produce a shoulder which serves for positioning of the gate contacts.

Referring to Fig. 1, a substrate 1 which may be associated with a single device or an array of devices is shown having a high conductivity lower region 2 and a device region 3 of moderate conductivity, each region having an alloyed metal ohmic contact 4 and 5.

For purposes of simplicity of explanation for the field effect device preferred embodiment, the semiconductor material will be arbitrarily chosen as GaAs and the conductivity type will be chosen as n, although it will be apparent to one skilled in the art in the light of the principles set forth that other semiconductors and the other conductivity type may be employed.

Referring next to Fig. 2, the horizontal dimensions, one of which is labelled W, of a mesa 6 are produced by fine line lithography. Since the FET device will need an ohmic drain contact at the top of the mesa to be fabricated, metal layer 4 is first applied to the substrate. Fine line lithography followed by an ion milling operation to a depth $H_1$ produces the structure shown in Fig. 2. A contact 5 will serve as the source of the FET device. The dimension W, the width of the channel, should be of the order of 0.1 to 0.5 microns, with the $H_1$ dimension being provided by the ion milling operation to a depth of about 0.35 microns.

In Fig. 3, a conformal coating 7 is deposited over the surface of the substrate and over the top and sides of the mesa 6. The coating may be applied by a conventional even coating process such as chemical vapor deposition, vacuum deposition and sputtering. The material employed for the coating is such that it may be removed from the horizontal areas without significant removal from the sides of the mesa. Some materials have a degree of anisotropy in etching such that the etching proceeds faster in the vertical direction and hence the material on the horizontal surfaces would be removed more rapidly. The materials $SiO_2$ and $Si_3N_4$ can exhibit etching anisotropy in plasma or reactive ion etching. The thickness of the coating 7 on the sides of the mesa 6 will determine the dimension of a shoulder. A coating 0.02 to 0.1 microns thick is satisfactory.

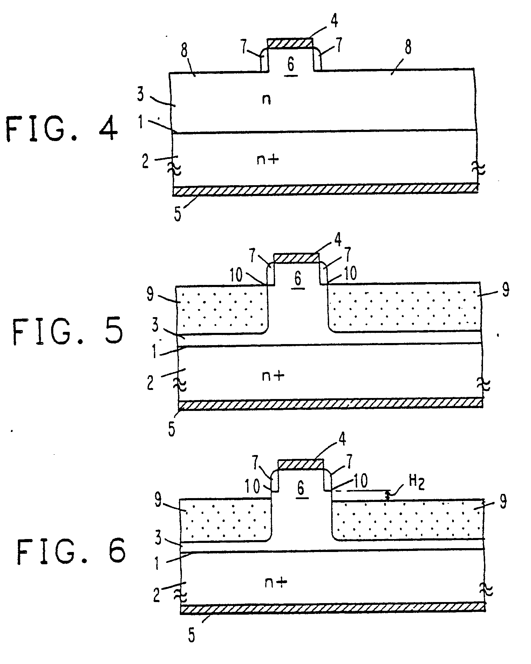

Referring next to Fig. 4, the conformal coating 7 is etched away from all horizontal surfaces leaving portions of the conformal coating 7 on the sides of the mesa 6 surrounded by the exposed surface 8 of the substrate 1.

In Fig. 5, a portion of the region 3 surrounding the mesa 6 is altered in characteristics in a vertically oriented step using the combination of the mesa and the remaining portions of the conformal coating 7 as a mask. The upper part of region 3 is converted to semi-insulating material 9 using a technique such as proton bombardment or oxygen implantation through the surface 8. Since the conversion by bombardment or implantation occurs in a direction perpendicular to the substrate, a shoulder 10 is protected by the lower edge of the remains of the conformal coating 7.

Referring next to Fig. 6, a further perpendicularly oriented eroding operation, eg an ion milling operation is performed on the converted region 9 to expose the shoulder 10 to a selected depth $H_2$ corresponding to the thickness of a metal coating that will become the gate of the FET.

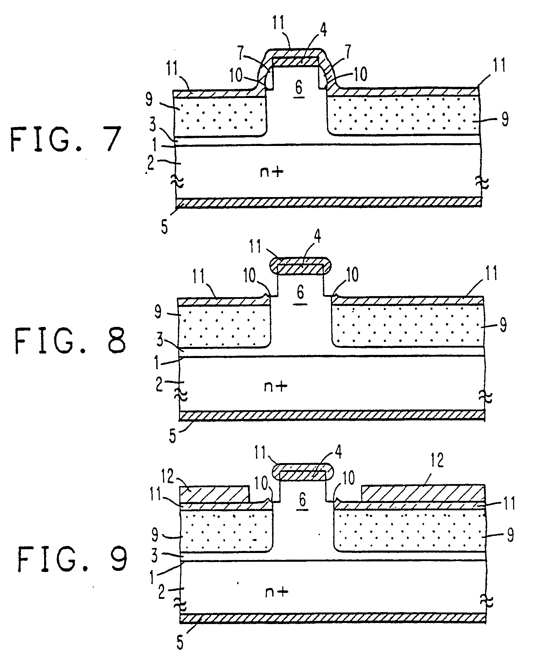

In Fig. 7, the shoulder is used to position gate electrodes for the FET. A metal layer 11 is first deposited over the surface of the semi-insulating region 9, the remnants of the conformal coating 7 and on the sides and top of the mesa 6.

Referring next to Fig. 8, the remaining portions of the conformal coating 7 are now dissolved in a standard "lift-off" operation, which separates the metal 11 at the shoulder 10. The remaining portions of the metal 11 on each side of the mesa 6 make Schottky barrier contacts there with and serve as gate electrodes of the FET. The mesa 6 itself serves as the channel and as part of the ohmic contact 4. The gate metal thickness at this stage is of the order to 0.01 to 0.1 microns.

The final structure is shown in Fig. 9. A thicker gate contact metal 12 has been applied by conventional deposition techniques to the thin gate metal electrodes 11. The thick metallization 12 reduces gate resistance.

Since the FET device is generally part of a chip, wafer or larger area, a larger contact to the ohmic drain contact 4 can be provided by producing an insulating region by proton bombardment and depositing thereon a metal electrode ohmically connected to contact 4.

What has been described is the use of an edge of a layer of deposited material to define a shoulder at an intermediate position between the base and the top of a mesa. A vertical field effect structure is illustrated wherein a mesa channel region has a stepped smaller drain region with the gate contact being made adjacent the step.

## Claims

1. A structure comprising a semiconductor portion surrounded by a semi-insulating portion (9), the semiconductor portion extending in the form of a mesa (6) above a substantially planar surface of the semi-insulating portion, the structure being characterised by the mesa (6) having a step (10) therein so that it consists of a lower part and an upper part, each of constant cross-section, the lower part having a greater cross-section than the upper part.

2. A structure as claimed in claim 1, in which said planar portion is a layer epitaxial to a substrate (2) having a higher conductivity than the layer.

3. A structure as claimed in claim 1 or claim 2, composed of gallium arsenide.

4. A vertical field effect transistor comprising a structure as claimed in any preceding claim, a Schottky barrier contact to the lower part of the mesa, the lower part serving as the channel region of the transistor, and individual ohmic contacts to the substrate and the top of the mesa.

5. A vertical field effect transistor as claimed in claim 4, in which there is a Schottky barrier contact on both sides of the lower part of the mesa.

6. A process of forming a semiconductor mesa with a lower part having a greater cross-section than the upper part of the mesa, the process comprising forming an original mesa (6) of constant cross-section, providing a conformal coating (7) on the sides of the original mesa, and downwardly eroding the material surrounding the original mesa using the conformal coating as a mask to form a final mesa consisting of an upper part (6) which was the original mesa and a lower part (10) of greater cross-section than the upper part.

7. A process as claimed in claim 6, in which the character of the material (9) surrounding the original mesa is modified prior to it being downwardly eroded.

8. A process as claimed in claim 7, in which the material (9) surrounding the original mesa is rendered semi-insulating prior to it being downwardly eroded.

9. A process as claimed in any of claim 6 to 8, in which the conformal coating is provided on the sides of the original mesa by forming a conformal coating on the top and sides of, and the area surrounding, the original mesa and downwardly etching away the conformal coating to remove it from the top of the original mesa and the area surrounding it but not from the sides of the original mesa.

10. A process as claimed in any of claims 6 to 9, in which the semiconductor is composed of gallium arsenide and the conformal coating consists of silicon nitride and/or silicon dioxide.

11. A process of forming a vertical semiconductor device including providing a semiconductor body with a mesa by a process as claimed in any of claim 6 to 10, coating the mesa and the area surrounding it with a metal layer (11) and dissolving away the conformal coating on the sides of the mesa so that the portions of the metal layer overlying the conformal coating are lifted off.

**Patentansprüche**

1. Aufbau mit einem Halbleiterabschnitt, welcher von einem halbleitenden Abschnitt (9) umgeben ist, wobei sich der Halbleiterabschnitt in Form einer Mesa (6) oberhalb einer im wesentlichen planaren Oberfläche des halbleitenden Abschnitts erstreckt, wobei der Aufbau dadurch gekennzeichnet ist, daß die Mesa (6) eine Stufe (10) enthält, so daß sie aus einem unteren Teil und einem oberen Teil besteht, von denen jeder konstanten Querschnitt hat, wobei der untere Teil einen größeren Querschnitt als der obere Teil hat.

2. Aufbau nach Anspruch 1, bei welchem der planare Abschnitt eine Schicht ist, welche epitaxial zu einem Substrat (2) ist, welches eine höhere Leitfähigkeit als die Schicht hat.

3. Aufbau nach Anspruch 1 oder 2, welcher aus Galliumarsenid aufgebaut ist.

4. Vertikaler Feldeffekttransistor mit einem Aufbau nach irgendeinem der vorstehenden Ansprüche, einem Schottky-Barrierenkontakt zum unteren Teil der Mesa, wobei der untere Teil als der Kanalbereich des Transistors dient, und eigenen ohmschen Kontakten zum Substrat und zur Oberseite der Mesa.

5. Vertikaler Feldeffekttransistor nach Anspruch 4, bei welchem ein Schottky-Barrierkontakt auf beiden Seiten des unteren Teils der Mesa vorhanden ist.

6. Verfahren zur Ausbildung einer Halbleitermesa mit einem unteren Teil, der einen größeren Querschnitt als der obere Teil der Mesa hat, wobei das Verfahren das Ausbilden einer ursprünglichen Mesa (6) konstanten Querschnitts, das Vorsehen einer konformen Beschichtung (7) auf den Seiten der ursprünglichen Mesa und das nach unten gerichtete Erodieren des die ursprüngliche Mesa umgebenden Materials unter Ausnützung der konformen Beschichtung als Maske zur Ausbildung einer Fertigmesa, welche aus einem oberen Teil (6), der die ursprüngliche Mesa war, und einem unteren Teil (10) größeren Querschnitts als der obere Teil besteht, umfaßt.

7. Verfahren nach Anspruch 6, bei welchem der Charakter des die ursprüngliche Mesa umgebenden Materials (9) modifiziert wird, bevor es nach unten erodiert wird.

8. Verfahren nach Anspruch 7, bei welchem das die ursprüngliche Mesa umgebende Material (9) halbleitende gemacht wird, bevor es nach unten erodiert wird.

9. Verfahren nach irgendeinem der Ansprüche 6 bis 8, bei welchem die konforme Beschichtung auf den Seiten der ursprünglichen Mesa dadurch vorgesehen wird, daß eine konforme Beschichtung oben und auf den Seiten der ursprünglichen Mesa und auf dem die ursprüngliche Mesa umgebenden Gebiet ausgebildet und die konforme Beschichtung nach unten weggeätzt wird, um sie oben von der ursprünglichen Mesa und von dem sie umgebenden Gebiet, nicht aber von den Seiten der ursprünglichen Mesa zu entfernen.

10. Verfahren nach irgendeinem der Ansprüche 6 bis 9, bei welchem der Halbleiter aus Galliumarsenid aufgebaut ist und die konforme Beschichtung aus Siliziumnitrid und/oder Siliziumdioxid besteht.

11. Verfahren zur Ausbildung einer vertikalen Halbleitervorrichtung, welches das Vorsehen eines Halbleiterkörpers mit einer Mesa nach einem Verfahren nach irgendeinem der Ansprüche 6 bis 10, das Beschichten der Mesa und des sie umgebenden Gebiets mit einer Metallschicht (11) und das Weglösen der konformen Beschichtung auf den Seiten der Mesa, so daß die Abschnitte der Metallschicht, die über der konformen Beschichtung liegen, abgehoben werden, umfaßt.

**Revendications**

1. Une structure comportant une partie semiconductrice entourée d'une partie semi-isolante (9), la partie semiconductrice s'étendant sous la forme d'un mesa (6) au dessus d'une surface sensiblement plane de la partie semi-isolante, cette structure étant caractérisée en ce que le mesa (6) comporte nach marche (10) telle que ce mesa soit formé d'une partie inférieure et d'une partie supérieure, chacune de section constante, la partie inférieure ayant une section supérieure à la partie inférieure.

2. La structure de la revendication 1, dans laquelle la partie plane est une couche épitaxiée sur un substrat (2) de conductivité supérieure à la couche.

3. La structure de la revendication 1 ou de la revendication 2, réalisée en arséniure de gallium.

4. Un transistor à effet de champ vertical comportant une structure selon l'une quelconque des revendications précédentes, un contact à barrière de Schottky sur la partie inférieure du mesa, cette partie inférieure formant la région de canal du transistor, et des contacts ohmiques séparés aboutissant au substrat et au sommet du mesa.

5. Le transistor à effet de champ vertical de la revendication 4, dans lequel il y a un contact à barrière de Schottky de part et d'autre de la partie inférieure du mesa.

6. Un processus de réalisation d'un mesa semiconducteur présentant une partie inférieure de section supérieure à la partie supérieure du mesa, ce processus comnportant les étapes suivantes: formation d'un mesa de départ (6) de section constante; mise en place d'un revêtement enrobant (7) sur les côtés du mesa départ; et érosion vers le bas du matériau entourant le mesa de départ en utilisant le revêtement enrobant comme masque, de manière à former un mesa final comprenant une partie supérieure (6) qui était celle du mesa de départ et une partie inférieure (10) de section plus élevée que la partie supérieure.

7. Le processus de la revendication 6, dans lequel, avant de l'éroder vers le bas, on modifie les caractéristiques du matériau (9) entourant le mesa de départ.

8. Le processus de la revendication 7, dans lequel, avant de l'éroder vers le bas, on rend semi-isolant le matériau (9) entourant le mesa de départ.

9. Le processus de l'une des revendications 6 à 8, dans lequel la mise en place d'un revêtement enrobant (7) sur les côtés du mesa de départ est effectuée en mettant en place le revêtement enrobant zur le sommet et les côtés du mesa de départ et sur la zone environnante puis en éliminant ce revêtement enrobant par gravure vers le bas, de de manière à éliminer celui-ci du sommet du mesa de départ et de la zone environnante, mais non des côtés du mesa de départ.

10. Le processus de l'une des revendications 6 à 9, dans laquelle le semiconducteur est formé d'arséniure de gallium et le revêtement enrobant est formé de nitrure de silicium et/ou de dioxyde de silicium.

11. Un processus de réalisation d'un composant semiconducteur vertical, comportant les étapes suivantes: formation d'un mesa sur un corps semiconducteur par un processus selon l'une des revendications 6 à 10; recouvrememment du mesa et de la région environnante par une couche métallique (11); et élimination, par dissolution, du revêtement enrobant sur les côtés du mesa, de manière à retirer par enlèvement les parties de la couche métallique recouvrant le revêtement enrobant.

FIG. 1

FIG. 2

FIG. 3

FIG. 4

FIG. 5

FIG. 6

FIG. 7

FIG. 8

FIG. 9